# EUROPÄISCHE PATENTSCHRIFT

(11) **EP 2 840 239 B1**
(45) Veröffentlichungstag und Bekanntmachung des Hinweises auf die Patenterteilung: **27.12.2017**
(21) Anmeldenummer: 14174019.1
(22) Anmeldetag: 26.06.2014
(51) Int. Cl.: F01M 1/10, F01M 5/00, F01M 1/16, H05K 7/20

(54) **Drehzahlvariable Fluid-Kühl-Filter-Anordnung**
Variable speed fluid coolant filter assembly
Installation de filtre de refroidissement de fluide à vitesse variable

(30) Priorität: 22.08.2013 DE 102013216627
(43) Veröffentlichungstag der Anmeldung: 25.02.2015
(73) Patentinhaber: ROBERT BOSCH GMBH, 70442 Stuttgart (DE)
(72) Erfinder: Doertoluk, Ibrahim, 63829 Krombach (DE); Schnurr, Bernd, 97816 Lohr-Sendelbach (DE)
(74) Vertreter: Thürer, Andreas

(56) Entgegenhaltungen:
- EP-A2- 0 965 737
- EP-A2- 1 239 129
- WO-A1-03/027456
- WO-A1-03/056153
- WO-A1-2007/000625
- JP-A- 2000 328 916

## Beschreibung

Die vorliegende Erfindung betrifft eine Fluid-Kühl-Filter-Anordnung, insbesondere eine Öl-Kühl-Filter-Anordnung.

### Stand der Technik

Gattungsgemäße Fluid-Kühl-Filter-Anordnungen weisen einen Fluidkreislauf mit einem Kühler und einem Filter auf und werden zur Kühlung und Filterung von Fluiden, insbesondere Öl, als Betriebsmittel in Maschinen verwendet. Das Öl kann dabei ein Getriebeöl, ein Motoröl, ein Hydrauliköl u.ä. sein und als Schmiermittel (in Getrieben bzw. Motoren) oder als Hydraulikflüssigkeit (in Hydraulikaggregaten) verwendet werden. In den genannten Maschinen wird dabei mechanische und hydraulische Energie in Wärme umgewandelt. Die Aufgabe des Kühlers ist es, die Wärme abzuführen, die Aufgabe des Filters ist es, Verunreinigungen, insbesondere Maschinenabrieb, auszufiltern.

Das Öl kann dazu mittels einer Fluidpumpe durch das Filter gefördert werden, woraufhin es der Maschine wieder zugeführt wird. Der Kühler verfügt über einen Wärmetauscher, um Wärme aus dem Öl in ein Kühlmittel abzuführen. In einfacher Ausgestaltung handelt es sich um einen Öl-Luft-Wärmetauscher, der zusätzlich mit einem Lüfter ausgestattet sein kann. Der Kühler kann als Hauptstromkühler, wobei das gesamte Öl durch den Kühler geleitet wird, oder als Nebenstromkühler, wobei nur ein Anteil des Öls (insbesondere temperaturabhängig) durch den Kühler geleitet wird, ausgebildet sein.

Je nach Einsatzzweck einer solchen Fluid-Kühl-Filter-Anordnung existiert im Stand der Technik eine große Variantenzahl hinsichtlich insbesondere der elektrischen Anschlüsse (Gleichspannung, Wechselspannung, Frequenz, Spannungsamplitude), der Umgebungsbedingungen (cold climate, hot climate, Belastungsfestigkeit usw.). Es ist daher wünschenswert, diese Variantenzahl zu reduzieren, um Logistik, Herstellung, Betrieb, Lagerhaltung, Wartung usw. zu vereinfachen.

### Offenbarung der Erfindung

Erfindungsgemäß wird eine Fluid-Kühl-Filter-Anordnung mit dem Merkmalen des Patentanspruchs 1 vorgeschlagen. Vorteilhafte Ausgestaltungen sind Gegenstand der Unteransprüche sowie der nachfolgenden Beschreibung.

### Vorteile der Erfindung

Die Erfindung schlägt eine Fluid-Kühl-Filter-Anordnung vor, bei der die Fluidpumpe und vorzugsweise auch der Lüfter jeweils von einen Elektromotor (im folgendem als Pumpenmotor bzw. Lüftermotor bezeichnet) angetrieben werden, wobei jeder der Elektromotoren von einem Stromrichter versorgt wird, so dass die Drehzahl des Elektromotors variabel in Abhängigkeit von entsprechenden Stellgrößen gesteuert werden kann.

Mit dieser Lösung kann zum einen sowohl die Filter- als auch die Kühlleistung an den momentanen Bedarf angepasst werden und gleichzeitig kann zum anderen lediglich durch Austausch der Stromrichter und unter Beibehaltung der übrigen Komponenten der Fluid-Kühl-Filter-Anordnung die Fluid-Kühl-Filter-Anordnung an unterschiedliche Gegebenheiten, insbesondere von Seiten der Stromversorgung, angepasst werden. Ein Stromrichter kann als Umrichter zum Wandeln zwischen zwei Wechselspannungen oder als Wechselrichter zum Wandeln von Gleichspannung in Wechselspannung ausgebildet sein. Durch die drehzahlvariable Ansteuerung wird die Energieeffizienz gesteigert, da immer nur soviel Fluid umgewälzt und gekühlt wird, wie im Moment nötig ist. Weiterhin werden dadurch auch die Betriebsgeräusche reduziert.

In einfacher Ausgestaltung kann vorgesehen sein, Lüftermotor und Pumpenmotor mit demselben Stromrichter zu betreiben. Dies reduziert die Variantenzahl weiter.

nis ein Stromrichter mit dem davon versorgten Elektromotor in einem gemeinsamen Gehäuse angeordnet sein.

Sind die Fluidpumpe als Verstellpumpe mit variablem Fördervolumen pro Arbeitsspiel (z.B. Umdrehung, Hub) (z.B. Schwenkscheibenbauweise) und/oder der Lüfter als Verstelllüfter mit variablem Luftdurchsatz ausgebildet, wird dadurch ein zweiter Freiheitsgrad für die Steuerung der Filter- bzw. Kühlleistung erhalten. Ein Verstelllüfter kann beispielsweise dadurch realisiert werden, dass eine elektromechanische oder hydraulische Verstellung von Anstellwinkeln von Lüfterradflügeln erfolgt, oder dass ein Abstand zwischen Lüfter und Kühlköper variable ist.

Dies kann in Kombination mit der zuvor erläuterten Ausführungsform mit nur einem gemeinsamen Stromrichter dazu verwendet werden, dennoch Fluidfördermenge und Luftfördermenge unabhängig voneinander vorzugeben, obwohl Lüftermotor und Pumpenmotor von demselben Stromrichter versorgt werden.

Die Fluidfördermenge wird in Abhängigkeit vom Lastzustand (z.B. Volllast, Teilllast, Stopp, Parken, Überlast usw.) der Maschine vorgegeben. Der Lastzustand kann extern, z.B. von einer Maschinensteuerung, übermittelt werden. Alternativ oder zusätzlich kann der Lastzustand durch Messung von Druck und/oder Temperatur und/oder Volumenstrom des Fluids vor dem Wärmetauscher (Wärmetauschereingang) und nach dem Wärmetauscher (Wärmetauscherausgang), vor dem Filter (Filtereingang) und nach dem Filter (Filterausgang) und durch Auswerten der Messwerte bestimmt werden.

Durch die Messung der Temperatur vor und nach dem Wärmetauscher und anschließende Differenzbildung kann durch Multiplikation mit Stoffwerten (Dichte, spezifische Wärmekapazität) die aktuelle abgeführte Verlustleistung berechnet werden. In Korrelation mit der Information über den Betriebszustand (z.B. mechanische Leistung) kann der aktuelle Wirkungsgrad des Getriebes bestimmt bzw. berechnet werden. Dies ermöglicht eine Art Condition Monitoring. Weicht der Wert signifikant von einem "Gut"-Zustand ab, ist dies ein Indiz für eine Beschädigung.

Durch die Messung des Drucks vor und nach dem Filter und anschließende Differenzbildung kann der Differenzdruck über dem Filter bestimmt werden. Die Veränderung des Differenzdrucks mit der Zeit gibt Aufschluss über einen Verschmutzungsgrad bzw. eine Verschmut-Durch die Messung des Drucks vor und nach dem Filter und anschließende Differenzbildung kann der Differenzdruck über dem Filter bestimmt werden. Die Veränderung des Differenzdrucks mit der Zeit gibt Aufschluss über einen Verschmutzungsgrad bzw. eine Verschmutzungsrate des Filters. Überschreitet der Verschmutzungsgrad einen Schwellwert, zeigt dies einen Wartungsbedarf an. Weicht die Verschmutzungsrate signifikant von einem Normalwert ab, ist dies ein Indikator für geänderte äußere Bedingungen (Umwelteinflüsse) oder erhöhte Partikelakkumulation durch mechanischen Abrieb. Diese Erkenntnis ermöglicht - z.B. durch einen früheren Wartungseinsatz - eine schleichende Schädigung des Getriebes zu verhindern.

Ebenso vorteilhaft wird die Luftfördermenge in Abhängigkeit von der Außentemperatur vorgegeben. Ist die Außentemperatur niedrig (cold climate), kann der Lüftermotor entweder ganz abgeschaltet werden oder mit niedriger Drehzahl betrieben werden. Die absolute Kühlleistung ist nämlich von der Temperaturdifferenz zwischen Außentemperatur und Fluidtemperatur abhängig. Wird die Außentemperatur sehr hoch (hot climate) wird die Lüfterdrehzahl zweckmäßigerweise maximiert.

Ebenso vorteilhaft wird bei der Vorgabe der Luftfördermenge auch die Höhe (NN) berücksichtigt, welche ebenfalls die Kühlleistung beeinflusst.

Die Kenntnis von Lufttemperatur und Lastzustand kann vorzugsweise auch für eine Plausibilisierung des Betriebs verwendet werden. Durch Überwachung eines z.B. empirisch ermittelten Zusammenhangs zwischen Lastzustand und Fluidtemperatur können mechanisch bedingte Fehler, die zu abweichenden Fluidtemperaturen führen, rechtzeitig erkannt werden. Der Zusammenhang ist zweckmäßigerweise in einem Kennfeld hinterlegt.

Durch das Vorgeben der Pumpendrehzahl bzw. Lüfterdrehzahl durch Stromrichter kann insbesondere beim Einschaltet eine Drehzahlrampe beginnend bei Null mit allmählichem Anstieg bis zur Solldrehzahl gefahren werden, wodurch sich Einschaltstrom und mechanische Belastung insbesondere im Vergleich zu einem Ein- und Ausschaltbetrieb reduzieren.

Durch einen im Stromrichter vorhandenen Zwischenkreiskondensator können überdies netzbedingte Ausfälle für eine gewisse Zeitdauer überbrückt werden. Gleiches gilt für netzbedingte Spannungserhöhungen, die durch den Stromrichter geglättet werden. Die Fluid-Kühl-Filter-Anordnung wird somit überbrückungsfähig (low voltage ride through (LVRT), high voltage ride through (HVRT) bzw. fault ride through (FRT)).

Um einen Kaltstart mit hoher Ölviskosität zu verbessern, wo eine hohe Stromaufnahme des Pumpenmotors zu erwarten ist, kann zur Entlastung der Stromversorgung der Pumpenmotor mittels einer Umschaltvorrichtung auf einen zuvor geladenen Energiespeicher geschaltet werden. Dabei wird der Pumpenmotor in der Kaltstartphase vom Energiespeicher versorgt und die Pumpe fördert währenddessen kaltes bzw. hochviskoses Fluid. Das hohe Drehmoment des Pumpenmotors bzw. der hohe Strom belasten dabei die Stromversorgung (z.B. das Stromnetz) nicht. Nach dem Kaltstart kann der Motor wieder über die Umschaltvorrichtung an die normale Stromversorgung geschaltet werden.

Weitere Vorteile und Ausgestaltungen der Erfindung ergeben sich aus der Beschreibung und der beiliegenden Zeichnung.

Es versteht sich, dass die vorstehend genannten und die nachfolgend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispiels in der Zeichnung schematisch dargestellt und wird im Folgenden unter Bezugnahme auf die Zeichnung ausführlich beschrieben.

### Figurenbeschreibung

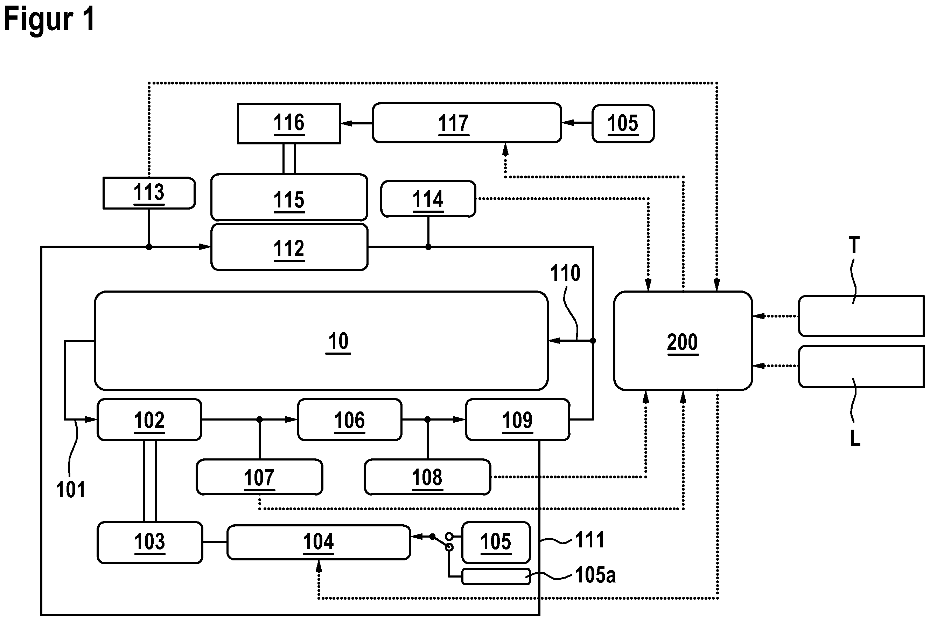

Figur 1 zeigt als Blockdiagramm eine bevorzugte Ausführungsform einer erfindungsgemäßen Fluid-Kühl-Filter-Anordnung.

### Detaillierte Beschreibung der Zeichnung

In Figur 1 ist eine bevorzugte Ausführungsform einer hier als Öl-Kühl-Filter-Anordnung ausgebildeten Fluid-Kühl-Filter-Anordnung als Blockdiagramm dargestellt und insgesamt mit 100 bezeichnet. Die Öl-Kühl-Filter-Anordnung dient dazu, hier Schmieröl als Betriebsmittel durch eine hier als Getriebe 10 ausgebildete Maschine zu pumpen und dabei zu filtern und gegebenenfalls zu kühlen. Dafür wird Öl aus einem Getriebesumpf entnommen und über eine Ölzuführleitung 101 einer Fluidpumpe 102 zugeführt. Die Fluidpumpe 102 wird drehzahlvariabel von einem Elektromotor bzw. Pumpenmotor 103 angetrieben, welcher von einem als Umrichter bzw. Frequenzumrichter 104 ausgebildeten Stromrichter versorgt wird. Der Umrichter 104 wiederum wird von einer Stromversorgung 105, insbesondere einem Stromnetz versorgt. Zwischen dem Umrichter 104 und der Stromversorgung 105 ist eine Umschalteinrichtung angeordnet, die die dazu eingerichtet ist, den Umrichter 104 zwischen dem Stromnetz 105 und einer weiteren Stromversorgung 105a, vorzugsweise einem Stromspeicher, wie einem Akku, umzuschalten. Dies dient beispielsweise dazu, um bei einem Kaltstart hohe Ströme nicht aus dem Stromnetz 105, sondern aus dem Stromspeicher 105a zu ziehen.

Von der Fluidpumpe 102 wird das Schmieröl durch ein Ölfilter 106 gepumpt, wobei filtereingangsseitig 107 und filterausgangsseitig 108 Messpunkte angeordnet sind, an denen eine Temperatur und/oder ein Druck und/oder ein Volumenstrom des Schmieröls erfasst werden. Die Messwerte werden einer Recheneinheit 200 zugeführt.

Nach dem Ölfilter 106 wird das Schmieröl durch ein temperaturgesteuertes Bypassventil 109 gepumpt, wo es in Abhängigkeit von der Öltemperatur anteilig direkt über eine Rückführleitung 110 dem Getriebe 10 oder über eine Kühlleitung 111 einem Kühlkörper 112 zugeführt wird. Auch eingangsseitig 113 und ausgangsseitig 114 des Kühlkörpers 112 werden Druck und/oder Temperatur und/oder Volumenstrom des Schmieröls erfasst und die Messwerte werden der Recheneinheit 200 zugeführt. Der Kühlkörper 112 ist Bestandteil eines Öl-/Luft-Wärmetauschers und wird von einem Lüfterrad 115, welches von einem als Elektromotor ausgebildeten Lüftermotor 116 angetrieben wird, mit Kühlluft als Kühlmittel versorgt. Der Lüftermotor 116 wird von einem hier ebenfalls als Frequenzumrichter 117 ausgebildeten Stromrichter versorgt, welche wiederum durch die Stromversorgung 105 versorgt wird.

Durch die Pfeile ist angedeutet, dass der Stromrichter 104 und der Stromrichter 117 von der Recheneinheit 200 angesteuert werden, um die Drehzahl des Pumpenmotors 103 bzw. des Lüftermotors 116 einzustellen. Die Drehzahleinstellung erfolgt vorzugsweise für den Lüftermotor 116 in Abhängigkeit von einer Außentemperatur T, die über einen entsprechenden Temperatursensor erfasst werden kann, und für den Pumpenmotor 103 in Abhängigkeit von einem Lastzustand L des Getriebes 10, welche beispielsweise von einer Maschinensteuerung an die Recheneinheit 200 übermittelt oder auf Grundlage der an den Punkten 107, 108, 113 und 114 gemessenen Messwerte innerhalb der Recheneinheit 200 berechnet wird.

Die beschriebene Öl-Kühl-Filter-Anordnung 100 eignet sich insbesondere zur Filterung und Kühlung von Getriebeöl in Energieerzeugungsanlagen, insbesondere Windenergieanlagen, welche meist autark arbeiten und nur bei Bedarf gewartet werden sollen. Die bevorzugte Öl-Kühl-Filter-Anordnung ermöglicht, dass die Leistungsaufnahme auf ein notwendiges Maß reduziert wird, welches sich von der benötigten Filterleistung und Kühlleistung ableitet. Durch den drehzahlvariablen Betrieb werden einerseits die Leistungsaufnahme und andererseits die Abnutzung der Komponenten reduziert, was insbesondere bei autark (z.B. off-shore) arbeitenden Windenergieanlagen besonders vorteilhaft ist, da hier der Reparatur- bzw. Wartungsaufwand entsprechend groß ist.

## Patentansprüche

1. Fluid-Kühl-Filter-Anordnung mit einer von einem Pumpenmotor (103) angetriebenen Fluidpumpe zum Pumpen eines Fluids durch ein Fluidfilter (106) und einem Fluidkühler (112) zum Kühlen des Fluids, wobei der Pumpenmotor (103) von einem Pumpen-Stromrichter versorgt wird, der dazu eingerichtet ist, eine Drehzahl des Pumpenmotors (103) in Abhängigkeit von einer Pumpenstellgröße zu steuern,
mit einer Recheneinheit, die dazu eingerichtet ist, den Pumpen-Stromrichter so anzusteuern, dass die Drehzahl des Pumpenmotors (103) in Abhängigkeit von einem Lastzustand einer mit dem Fluid betriebenen Maschine (10) gesteuert wird, insbesondere in Abhängigkeit vom Lastzustand (L) eines Getriebes,
mit einer Sensoreinrichtung zur Messung eines Fluiddrucks und/oder einer Fluidtemperatur und/oder eines Fluidvolumenstroms als wenigstens einen Messwert in einem Eingang des Fluidfilters (106) und/oder in einem Ausgang des Fluidfilters (106) und/oder in einem Eingang des Fluidkühlers (112) und/oder in einem Ausgang des Fluidkühlers (112), wobei die Recheneinheit dazu eingerichtet ist, aus dem wenigstens einen Messwert den Lastzustand zu bestimmen.

2. Fluid-Kühl-Filter-Anordnung nach Anspruch 1, wobei die Fluidpumpe eine Verstellpumpe mit extern vorgebbarem Fördervolumen pro Arbeitsspiel ist.

3. Fluid-Kühl-Filter-Anordnung nach Anspruch 1 oder 2, mit einem Lüfter zum Zuführen von Luft zum Fluidkühler (112), wobei der Lüfter ein von einem Lüftermotor (116) angetriebenes Lüfterrad (115) aufweist, wobei der Lüftermotor (116) von einem Lüfter-Stromrichter (117) versorgt wird, der dazu eingerichtet ist, eine Drehzahl des Lüftermotors (116) in Abhängigkeit von einer Lüfterstellgröße zu steuern.

4. Fluid-Kühl-Filter-Anordnung nach Anspruch 3, wobei der Lüfter ein Verstelllüfter mit extern vorgebbarem Luftdurchsatz ist.

5. Fluid-Kühl-Filter-Anordnung nach Anspruch 3 oder 4, wobei der Pumpen-Stromrichter der Lüfter-Stromrichter (117) ist.

6. Fluid-Kühl-Filter-Anordnung nach Anspruch 1, wobei die Recheneinheit dazu eingerichtet die Drehzahl des Pumpenmotors (103) beim Einschalten allmählich zu erhöhen.

7. Fluid-Kühl-Filter-Anordnung nach Anspruch 1 oder 6, zumindest in Rückbezug auf Anspruch 3, wobei die Recheneinheit dazu eingerichtet ist, den Lüfter-Stromrichter (117) so anzusteuern, dass die Drehzahl des Lüftermotors (116) in Abhängigkeit von einer Temperatur gesteuert wird.

8. Fluid-Kühl-Filter-Anordnung nach einem der vorstehenden Ansprüche, mit einer Umschalteinrichtung, die dazu eingerichtet ist, den Pumpen-Stromrichter zwischen einer ersten Stromversorgung (105) und einer zweiten Stromversorgung (105a) umzuschalten.

## Claims

1. Fluid cooling and filtering arrangement having a fluid pump which is driven by a pump motor (103) and which serves for pumping a fluid through a fluid filter (106), and having a fluid cooler (112) for cooling the fluid, wherein the pump motor (103) is fed by a pump current converter which is designed to control a rotational speed of the pump motor (103) in dependence on a pump actuating variable,
having a processing unit which is designed to activate the pump current converter such that the rotational speed of the pump motor (103) is controlled in dependence on a load state of a machine (10) operated with the fluid (10), in particular in dependence on the load state (L) of a gear mechanism,
having a sensor device for measuring a fluid pressure and/or a fluid temperature and/or a fluid volume flow as at least one measurement value at an inlet of the fluid filter (106) and/or at an outlet of the fluid filter (106) and/or at an inlet of the fluid cooler (112) and/or at an outlet of the fluid cooler (112), wherein the processing unit is designed to determine the load state from the at least one measurement value.

2. Fluid cooling and filtering arrangement according to Claim 1, with the fluid pump being a variable displacement pump with an externally predefinable pumping volume per working cycle.

3. Fluid cooling and filtering arrangement according to Claim 1 or 2, having a fan for feeding air to the fluid cooler (112), wherein the fan has a fan wheel (115) driven by a fan motor (116), wherein the fan motor (116) is fed by a fan current converter (117) which is designed to control a rotational speed of the fan motor (116) in dependence on a fan actuating variable.

4. Fluid cooling and filtering arrangement according to Claim 3, with the fan being a variable displacement fan with an externally predefinable air throughput.

5. Fluid cooling and filtering arrangement according to Claim 3 or 4, with the pump current converter being the fan current converter (117).

6. Fluid cooling and filtering arrangement according to Claim 1, wherein the processing unit is designed to increase the rotational speed of the pump motor (103) gradually during switching-on.

7. Fluid cooling and filtering arrangement according to Claim 1 or 6, at least referring back to Claim 3, wherein the processing unit is designed to activate the fan current converter (117) such that the rotational speed of the fan motor (116) is controlled in dependence on a temperature.

8. Fluid cooling and filtering arrangement according to one of the preceding claims, having a switching device which is designed to switch the pump current converter between a first current supply (105) and a second current supply (105a).

## Revendications

1. Agencement de filtre de refroidissement de fluide comprenant une pompe de fluide entraînée par un moteur de pompe (103) pour pomper un fluide à travers un filtre à fluide (106) et un refroidisseur de fluide (112) pour refroidir le fluide, le moteur de pompe (103) étant alimenté par un convertisseur de pompe, qui est prévu pour commander un régime du moteur de pompe (103) en fonction d'une grandeur de commande de la pompe, comprenant une unité de calcul qui est prévue pour commander le convertisseur de pompe de telle sorte que le régime du moteur de pompe (103) soit commandé en fonction d'un état de charge d'une machine (10) fonctionnant avec le fluide, en particulier en fonction de l'état de charge (L) d'une transmission,
comprenant un dispositif de capteur pour mesurer une pression de fluide et/ou une température de fluide et/ou un débit volumique de fluide sous forme d'au moins une valeur de mesure dans une entrée du filtre à fluide (106) et/ou dans une sortie du filtre à fluide (106) et/ou dans une entrée du refroidisseur de fluide (112) et/ou dans une sortie du refroidisseur de fluide (112), l'unité de calcul étant prévue pour déterminer l'état de charge à partir de l'au moins une valeur de mesure.

2. Agencement de filtre de refroidissement de fluide selon la revendication 1, dans lequel la pompe de fluide est une pompe variable avec un volume de refoulement par cycle de travail prédéfinissable depuis l'extérieur.

3. Agencement de filtre de refroidissement de fluide selon la revendication 1 ou 2, comprenant un ventilateur pour acheminer de l'air au refroidisseur de fluide (112), le ventilateur présentant une roue de ventilateur (115) entraînée par un moteur de ventilateur (116), le moteur de ventilateur (116) étant alimenté par un convertisseur de ventilateur (117) qui est prévu pour commander un régime du moteur de ventilateur (116) en fonction d'une grandeur de réglage du ventilateur.

4. Agencement de filtre de refroidissement de fluide selon la revendication 3, dans lequel le ventilateur et un ventilateur variable avec un débit d'air prédéfinissable depuis l'extérieur.

5. Agencement de filtre de refroidissement de fluide selon la revendication 3 ou 4, dans lequel le convertisseur de pompe est le convertisseur de ventilateur (117).

6. Agencement de filtre de refroidissement de fluide selon la revendication 1, dans lequel l'unité de calcul est prévue pour augmenter progressivement le régime du moteur de pompe (103) lors de sa mise en route.

7. Agencement de filtre de refroidissement de fluide selon la revendication 1 ou 6 au moins lorsqu'elle se réfère à la revendication 3, dans lequel l'unité de calcul est prévue pour commander le convertisseur de ventilateur (117) de telle sorte que le régime du moteur de ventilateur (116) soit commandé en fonction d'une température.

8. Agencement de filtre de refroidissement de fluide selon l'une quelconque des revendications précédentes, comprenant un dispositif de commutation qui est prévu pour commuter le convertisseur de pompe entre une première alimentation en courant (105) et une deuxième alimentation en courant (105a).
